**Europäisches Patentamt**

**European Patent Office**

**Office européen des brevets**

(19)

(11) Veröffentlichungsnummer : **0 063 636 B2**

(12) # NEUE EUROPÄISCHE PATENTSCHRIFT

(45) Veröffentlichungstag der neuen Patentschrift :
**30.12.92 Patentblatt 92/53**

(51) Int. Cl.⁵ : **H01F 40/06**

(21) Anmeldenummer : **81105435.2**

(22) Anmeldetag : **11.07.81**

---

(54) **Ringkernstromwandler zum Einbau in eine metallgekapselte Hochspannungsschaltanlage.**

---

(30) Priorität : **28.04.81 CH 2754/81**

(43) Veröffentlichungstag der Anmeldung :
**03.11.82 Patentblatt 82/44**

(45) Bekanntmachung des Hinweises auf die
Patenterteilung :
**26.09.84 Patentblatt 84/39**

(45) Bekanntmachung des Hinweises auf die
Entscheidung über den Einspruch :
**30.12.92 Patentblatt 92/53**

(84) Benannte Vertragsstaaten :
**AT BE CH DE FR GB IT LI LU NL SE**

(56) Entgegenhaltungen :
**CH-A- 514 923**
**DE-C- 683 018**
**FR-A- 1 100 351**
**US-A- 4 104 497**

(73) Patentinhaber : **Sprecher + Schuh AG**
**Buchserstrasse 7**
**CH-5001 Aarau (CH)**

(72) Erfinder : **Stephanides, Viktor H., Dr.**
**Engimattstrasse 26**
**CH-8002 Zürich (CH)**

(74) Vertreter : **Monsch, René**
**E. BLUM & CO., Patentanwälte Vorderberg 11**
**CH-8044 Zürich (CH)**

EP 0 063 636 B2

**Beschreibung**

Die vorliegende Erfindung betrifft einen Ringkernstromwandler zum Einbau in eine metallgekapselte Hochspannungsschaltanlage mit mindestens einem mit Sekundärwicklung versehenen innerhalb der Kapselung angeordneten Ringkern und einem in der Oeffnung des Ringkernes verlaufenden Primärleiter, wobei zwischen dem Ringkern und dem Primärleiter ein am einen Ende mit der Kapselung elektrisch leitend verbundenes und an den übrigen Stellen davon elektrisch isoliertes, inneres Rohr vorgesehen ist.

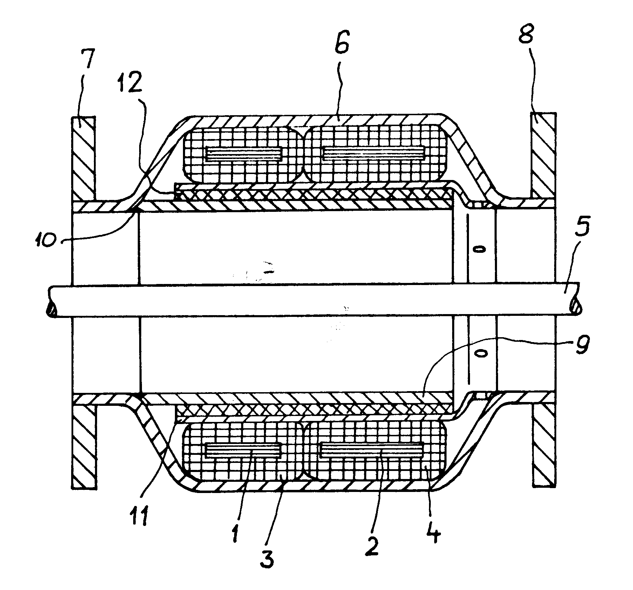

Aus der BBC-Mitt. 54 (1967), H. 12, S. 770, Bild 2, oder aus der CH-A-570 685 ist ein Ringkernstromwandler der eingangs erwähnten Art bekannt. Bei diesem Stromwandler können an den Sekundärklemmen sehr hohe, meistens über 1 000 V Scheitelwert aufweisende Spannungen auftreten, wenn ein spannungsloser, eine kleine Kapazität darstellender Anlagenteil zugeschaltet wird, oder wenn ein kleiner kapazitiver Strom bei einer Unterbrechung " abgerissen " wird. In diesen Fällen entsteht eine Wanderwelle, die sich vom Entstehungsort des Zünd- resp. abgerissenen Ausschaltlichtbogens beidseitig ausbreitet und Frontzeiten zwischen 2 und 300 ns aufweisen kann. Nachdem das innere Rohr frei endet, läuft die Wanderwelle einerseits im Innenleiter durch die Oeffnung der Ringkerne und anderseits in der Kapselung um die Ringkerne herum. Die im Innenleiter geführte Wanderwelle induziert in der Stromwandlerwicklung eine sehr hohe Spannung. Bei dieser Anordnung besteht zwischen der Wanderwelle in der Kapselung und der Sekundärwicklung des Stromwandlers eine kapazitive Koppelung. Somit wird das Potential der Sekundärwicklung durch die Wanderwelle kapazitiv erhöht. Je nach Laufrichtung der Wanderwelle entsteht ausserdem am freien Ende des inneren Rohres eine Reflexion, weil die Länge dieses inneren Rohres meistens in der Grössenordnung der Frontlänge der Wanderwelle liegt. Die reflektierte Welle ist mit der Stromwandlerwicklung kapazitiv gekuppelt und trägt zu deren Potentialerhöhung auch bei.

Aufgabe der Erfindung ist es, einen Ringkernstromwandler der eingangs erwähnten Art zu schaffen, an dessen Sekundärklemmen bei der Zuschaltung spannungsloser, eine kleine Kapazität darstellender Anlagenteile oder beim Abreissen kleiner kapazitiver Ströme bei der Unterbrechung keine Gefahr bedeutenden Ueberspannungen auftreten.

Die gestellte Aufgabe ist dadurch gelöst, daß ein an der der elektrischen Verbindungsstelle (10) zwischen der Kapselung (6) und dem inneren Rohr (9) abgekehrten Seite des Ringkernes (1, 2) mit der Kapselung (6) elektrisch leitend verbundener und an den übrigen Stellen davon elektrisch isolierter, das innere Rohr (9) mindestens teilweise überlappender, elektrisch leitender zylindrischer Abschirmkörper (11) vorhanden ist, und daß der Überlappungsteil des Abschirmkörpers einschließlich der zwischen ihm und dem inneren Rohr liegenden Isolation zur Bildung einer für das ungehinderte Weiterleiten steiler-Wanderwellen ausreichenden Kapazität bemessen sind.

Durch diese Massnahme wird erreicht, dass eine steile Wanderwelle an den Sekundärklemmen des Stromwandlers praktisch keine Ueberspannung verursacht. Das Gehäuse, das innere Rohr und der das innere Rohr überlappende Abschirmkörper bilden nämlich für steile Wanderwellen am Ringkern eine Kurzschlusswindung. Diese Kurzschlusswindung verhindert das Entstehen einer hohen induzierten Spannung an den Sekundärklemmen des Stromwandlers. Die Ueberlappungsstelle zwischen innerem Rohr und Abschirmkörper ist anderseits für steile Wanderwellen eine Längskupplung. Die Wanderwelle wird bei dieser Anordnung an der äusseren Oberfläche des Innenleiters und an der inneren Oberfläche der Kapselung resp. des inneren Rohres und des Abschirmkörpers geführt. Eine kapazitive Koppelung zwischen der Wanderwelle und der Sekundärwicklung besteht hier nicht. Am inneren Rohr wird hier auch keine Reflexion der Wanderwellen auftreten, was auch zur Verringerung der durch kapazitive Koppelung bedingte Potentialerhöhung der Sekundärwicklung beiträgt.

Aus der CH-A-514 923 ist zwar bekannt, für Ringkernstrowandler mit ausserhalb der Kapselung angebrachten Ringkernen die in der Oeffnung der Ringkerne geführte Kapselung aus teilweise ineinandergeschobenen, voneinander durch eine dazwischengelegte Isolationsschicht elektrisch isolierten Kapselungsrohren auszubilden. Bei diesem Stromwandler muss die zwischen den ineinandergeschobenen Kapselungsrohren angebrachte Isolation einen gasdichten Abschluss der Schaltanlage bilden. Dieser elektrisch isolierte Spalt in der Kapselung dient eindeutig zur Unterbindung von die Messung verfälschenden Strömen in der Kapselung. Bei dieser Lösung tritt das eingangs behandelte Problem der hohen Ueberspannungen an den Sekundärklemmen des Stromwandlers gar nicht auf, weil die Ueberlappung der Kapselungsrohre die Ueberspannungen im Sinne der vorliegenden Erfindung gar nicht zulässt. Aus dieser vorbekannten Lösung hat der Fachmann weder die hier gestellte Aufgabe noch Hinweise zu ihrer Lösung entnehmen können.

Der Abschirmkörper liegt zweckmässigerweise zwischen dem Ringkern und dem inneren Rohr und besteht aus einem nicht ferromagnetischen Material.

Im folgenden wird anhand der beiliegenden einzigen Zeichnung ein Ausführungsbeispiel der Erfindung beschrieben.

Die Ringkerne 1, 2 sind mit Sekundärwicklungen 3, 4 versehen. Der Primärleiter 5 ist durch die Oeffnung der Ringkerne 1, 2 geführt. Die Ringkerne 1, 2 sind in der Kapselung 6 untergebracht. Die Kapselung 6 ist mit Anschlussflanschen 7, 8 ausgerüstet, die den

Anschluss an den übrigen Anlagenteilen ermöglichen. An der Kapselung 6 ist das innere Rohr 9 an der Stelle 10 angeschweisst. Dieses innere Rohr 9 ragt durch die Oeffnungen der Ringkerne 1, 2 hindurch und endet frei. An der der elektrischen Verbindungsstelle 10 abgekehrten Seite der Ringkerne 1 und 2 ist der aus rostfreiem Stahl hergestellte Abschirmkörper 11 angeschweisst, der ebenfalls von der anderen Seite durch die Oeffnung der Ringkerne 1, 2 hindurchragt und frei endet. Zwischen dem inneren Rohr 9 und dem Abschirmkörper 11 ist eine elektrische Isolationsschicht 12 angebracht.

Beim Auftreten einer steilen Wanderwelle bilden die Kapselung 6, das innere Rohr 9, der Abschirmkörper 11 und die Kapazität zwischen dem inneren Rohr 9 und dem Abschirmkörper 11 eine Kurzschlusswindung für die Ringkerne 1 und 2, die das Auftreten hoher induzierter Spannungen an den Sekundärklemmen des Stromwandlers verhindert. Die steile Wanderwelle kann über die zwischen dem inneren Rohr 9 und dem Abschirmkörper 11 durch die Ueberlappung gebildete, relativ grosse Kapazität praktisch ungehindert, ohne Reflexion weiterlaufen und erhöht kapazitiv das Potential der Sekundärwicklungen 3, 4 nicht.

## Patentansprüche

1. Ringkernstromwandler zum Einbau in eine metallgekapselte-Hochspannungsschaltanlage mit mindestens einem mit Sekundärwicklung (3, 4) versehenen innerhalb der Kapselung (6) angeordneten Ringkern (1, 2) und einem in der Öffnung des Ringkernes verlaufenden Primärleiter (5), wobei zwischen dem Ringkern (1,2) und dem Primärleiter (5) ein am einen Ende mit der Kapselung (6) elektrisch leitend.verbundenes und an den übrigen Stellen davon elektrisch isoliertes, inneres Rohr (9) vorgesehen ist, dadurch gekennzeichnet, daß ein an der der elektrischen Verbindungsstelle (10) zwischen der Kapselung (6) und dem inneren Rohr (9) abgekehrten Seite des Ringkernes (1, 2) mit der Kapselung (6) elektrisch leitend verbundener und an den übrigen Stellen davon elektrisch isolierter, das innere Rohr (9) mindestens teilweise überlappender, elektrisch leitender zylindrischer Abschirmkörper (11) vorhanden ist, und daß der Überlappungsteil des Abschirmkörpers einschließlich der zwischen ihm und dem inneren Rohr liegenden Isolation zur Bildung einer für das ungehinderte Weiterleiten steiler-Wanderwellen ausreichenden Kapazität bemessen sind.

2. Ringkernstromwandler nach Anspruch 1, dadurch gekennzeichnet, dass der Abschirmkörper (11) zwischen dem Ringkern (1, 2) und dem inneren Rohr (9) liegt.

3. Ringkernstromwandler nach Anspruch 1 oder 2, dadurch gekennzeichnet, dass der Abschirmkörper (11) aus einem nicht ferromagnetischen Material besteht.

## Claims

1. Current transformer with a ring shaped core for use in a high voltage switching device enclosed in a metallic casing (6), within which the transformer has at least one ring-shaped core (1, 2) with a secondary winding (3, 4), where the transformer further has a primary conductor (5) located within the opening of the ring core, and where there is provided between said ring core (1, 2) and said primary conductor (5) an inner tube (9), one end of which is electrically connected with the casing (6), whilst its other parts are electrically isolated from the same, characterized by an electrically conductive, cylindric screening shield (11), which at the end of the ring core (1, 2) distal from the electrical connection (10) between the casing (6) and the inner tube (9), is electrically connected to the casing (6), whilst the other parts of the shield are insulated therefrom and the shield at least partially overlaps the inner tube, and characterized in that the overlapping part of the screening shield including the insulation located between the same and the inner tube are dimensioned to provide a capacity sufficient for unhindered transmission of steep travelling waves.

2. Current transformer according to claim 1, characterized in that the screening shield (11) is located between the ring core (1, 2) and the inner tube (9).

3. Current transformer according to claim 1 or 2, characterized in that the screening shield (11) is made of a nonferromagnetic material.

## Revendications

1. Transformateur à noyau annulaire destiné à être monté dans une installation de commutation à haute tension à blindage métallique, avec au moins un noyau annulaire (1,2) disposé à l'intérieur du blindage (6) et pourvu d'un enroulement secondaire (3,4) et un conducteur primaire (5) passant dans l'ouverture du noyau annulaire, un tube intérieur (9) étant prévu entre le noyau annulaire (1,2) et le conducteur primaire (5) avec une de ses extrémités connectée électriquement au blindage (6) tout en étant isolé de celui-ci partout ailleurs, caractérisé par un élément de blindage (11) cylindrique conducteur de l'électricité, recouvrant au moins partiellement le tube intérieur (9), cet élément de blindage étant connecté électriquement au blindage (6) du côté du noyau annulaire (1,2) opposé au point de la connexion électrique (10) entre le blindage (6) et le tube intérieur (9), tout en étant isolé électriquement du blindage aux autres endroits et par le fait que la partie de recouvrement de l'élément de blindage y compris l'isolation se trouvant entre cet élément et le tube intérieur est mesurée pour former une capacité suffisante pour la transmission sans obstacle d'ondes progressives à front raide.

2. Transformateur à noyau annulaire, selon la revendication 1, caractérisé en ce que l'élément de blindage (11) est situé entre le noyau annulaire (1,2) et le tube intérieur (9).

3. Transformateur à noyau annulaire, selon la revendication 1 ou 2, caractérisé en ce que l'élément de blindage (11) est réalisé en un matériau non ferromagnétique.